# FASCICULE DE BREVET EUROPEEN

(11) **EP 1 436 896 B1**
(45) Date de publication et mention de la délivrance du brevet: **24.01.2007**
(21) Numéro de dépôt: 02781218.9
(22) Date de dépôt: 27.09.2002
(51) Int. Cl.: H03L 7/197

(54) **CIRCUIT COMPTEUR DIVISEUR DOUBLE MODE A PHASE COMMUTEE POUR UN SYNTHETISEUR DE FREQUENCE**
PHASENUMGESCHALTETE DOPPELMODUS-TEILERZÄHLERSCHALTUNG FÜR EINEN FREQUENZSYNTHESIZER
PHASE-SWITCHED DUAL-MODE DIVIDER COUNTER CIRCUIT FOR A FREQUENCY SYNTHESIZER

(30) Priorité: 05.10.2001 EP 01203761
(43) Date de publication de la demande: 14.07.2004
(73) Titulaire: ASULAB S.A., 2074 Marin (CH)
(72) Inventeur: CASAGRANDE, Arnaud, CH-2523 Lignières (CH)
(74) Mandataire: Laurent, Jean
(86) Numéro de dépôt international: PCT/EP2002/011178
(87) Numéro de publication internationale: WO 2003/032495

(56) Documents cités:
- US-A- 5 311 152
- US-A- 5 781 054
- PATENT ABSTRACTS OF JAPAN vol. 2002, no. 02, 2 avril 2002 (2002-04-02) -& JP 2001 285061 A (SHARP CORP), 12 octobre 2001 (2001-10-12)

## Description

L'invention concerne un circuit compteur diviseur double mode à phase commutée pour un synthétiseur de fréquence. Ledit circuit divise la fréquence d'au moins un signal à haute fréquence par un premier facteur dans un premier mode sélectionné et par un second facteur dans un second mode sélectionné. Il comprend plusieurs diviseurs par deux connectés en série du type asynchrone. Un des diviseurs par deux est du type maître-esclave pour recevoir deux signaux d'entrée en opposition de phase et fournir quatre signaux déphasés de 90° l'un par rapport à l'autre. Le circuit comprend également un bloc sélecteur de phase intercalé entre deux des diviseurs par deux pour recevoir les quatre signaux déphasés du premier diviseur maître-esclave et fournir un des quatre signaux déphasés sélectionné au second diviseur. Pour la sélection des signaux déphasés, des signaux de commande sont fournis par un bloc de commande au bloc sélecteur de phase.

Les synthétiseurs de fréquence sont utilisés notamment dans des systèmes de communication sans fils ou, plus généralement, dans des systèmes de télécommunication afin de fournir des signaux à haute fréquence. Les signaux à haute fréquence sont susceptibles d'être utilisés par exemple pour des opérations de démodulation de signaux RF reçus.

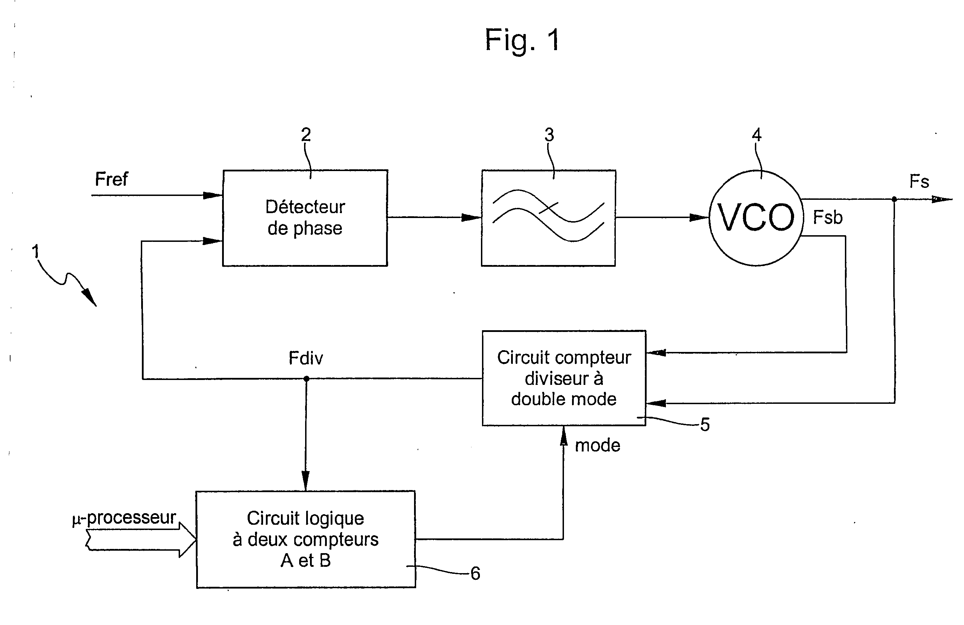

La figure 1 représente une forme de réalisation d'un synthétiseur de fréquence conventionnel avec un circuit compteur diviseur double mode. Ce synthétiseur comprend tout d'abord un oscillateur de référence, non représenté. Cet oscillateur fournit un signal de référence Fref à fréquence stable à un détecteur de phase et de fréquence 2. Ce détecteur reçoit également un signal à fréquence divisée Fdiv d'un circuit compteur diviseur double mode 5 afin de comparer le signal de référence et le signal à fréquence divisée. En fonction de la différence de phase et de fréquence des signaux Fref et Fdiv, le détecteur fournit un signal de comparaison à un filtre passe-bas 3 relié à un oscillateur commandé en tension 4 (VCO). Cet oscillateur commandé en tension reçoit un signal de commande en tension provenant du filtre passe-bas afin que cet oscillateur produise au moins un signal à haute fréquence dépendant de la comparaison entre les signaux Fref et Fdiv.

L'oscillateur commandé en tension peut être un oscillateur du type différentiel afin de fournir deux signaux à haute fréquence Fs et Fsb en opposition de phase au circuit compteur diviseur 5 dans une boucle à blocage de phase. Au moins un des signaux à haute fréquence Fs ou Fsb peut être ainsi utilisé pour des opérations de démodulation dans un récepteur de signaux radiofréquences par exemple.

Le circuit compteur diviseur double mode 5 a la faculté de permettre une division de fréquence selon un facteur de division dépendant d'un mode sélectionné. Pour ce faire, un circuit logique à deux compteurs A et B est généralement utilisé pour fournir une sélection de mode au circuit compteur diviseur. Ce circuit logique 6, bien connu dans ce domaine technique, est commandé par un microprocesseur et par le signal à fréquence divisée Fdiv. Les deux compteurs A et B sont en principe cadencés en synchronisme par un même signal d'horloge, mais le nombre compté par chaque compteur avant une remise à zéro est différent. Cela permet ainsi au circuit logique 6 de fournir un signal de mode au circuit compteur diviseur afin de changer de mode de division dans des périodes déterminées.

Plusieurs réalisations de circuits compteurs diviseurs du type double mode ont déjà été proposées, mais comme ces circuits doivent fonctionner à haute vitesse, ils sont plus difficiles à concevoir que de simples diviseurs de fréquence à rapport de division fixe. Une des difficultés est que la partie logique du circuit, pour obtenir une division de fréquence selon des premier et second facteurs de division, ralentit tout le circuit.

A titre d'exemple de réalisation, le brevet US 6,067,339 décrit un circuit compteur diviseur double mode conventionnel. Selon le mode choisi, le facteur de division peut être égal à 64 ou à 65, ou également à 128 ou à 130. Ce circuit est constitué notamment d'une première partie de division synchrone, pour la sélection du facteur de division, et d'une seconde partie de division asynchrone. Pour ce faire, le circuit comprend plusieurs diviseurs par deux connectés en série. Un bloc de diviseurs est synchrone pour opérer une division par 4 ou par 5, alors que les autres diviseurs sont du type asynchrone. Un autre circuit conventionnel est décrit dans US 5,781,054.

Ce bloc de diviseurs synchrones est agencé avec un certain nombre de portes logiques afin de permettre au circuit de diviser le signal à haute fréquence par un des deux facteurs de division sélectionné. Les portes logiques placées sur le chemin critique dudit bloc de diviseurs synchrones peut causer une diminution dans la fréquence d'entrée maximum. Le bloc comprend trois bascules du type D cadencées par un même signal d'horloge qui est un signal de sortie d'un premier diviseur par deux. Cependant, une des bascules de ce bloc n'est utilisée que pour obtenir le facteur de division par 65 ou par 130.

Habituellement, un bloc de diviseurs synchrones de ce type est destiné à recevoir directement le signal à haute fréquence. Ainsi, plusieurs bascules du bloc de diviseurs synchrones fonctionnent à fréquence élevée ce qui peut être un inconvénient notamment du point de vue de la consommation. Une solution à ce problème a été partiellement résolue par le circuit décrit dans ce brevet US 6,037,339 en plaçant un premier diviseur par deux du type asynchrone avant le bloc de diviseurs synchrones. Toutefois, le premier diviseur ne fait que diviser par deux la fréquence du signal à haute fréquence ce qui fait que les bascules du bloc de diviseurs synchrones doivent fonctionner avec une fréquence qui est encore trop élevée.

Un autre inconvénient avec un tel montage est que la division de fréquence ne peut pas être ajustée finement selon les deux facteurs de division, étant donné qu'un premier diviseur par deux est notamment utilisé pour diminuer la fréquence d'un signal à haute fréquence. Il n'est donc pas possible de fournir des divisions de fréquence avec des facteurs de division plus proche l'un de l'autre.

Pour éviter l'utilisation d'un bloc de diviseurs synchrones, une forme d'exécution d'un circuit compteur diviseur double mode est présentée dans l'article rédigé par Mrs Jan Craninckx et Michiel S. J. Steyaert, publié dans le journal IEEE des circuits intégrés, volume 31 du 7 juillet 1996. Ce circuit compteur diviseur double mode ne comprend que des diviseurs par deux connectés en série du type asynchrone comme pour la présente invention. Ce circuit à double mode comprend donc une chaîne de sept diviseurs par deux asynchrones interrompue par un bloc sélecteur de phase pour permettre une division de fréquence par 128 ou par 129. Uniquement le premier diviseur par deux fonctionne à la fréquence la plus élevée, c'est-à-dire à la fréquence d'au moins un signal à haute fréquence Fin reçu.

Un deuxième diviseur par deux du type maître-esclave est connecté au premier diviseur par deux. Ce second diviseur maître-esclave est destiné à fournir quatre signaux déphasés de 90° l'un par rapport à l'autre au bloc sélecteur de phase sur la base de deux signaux en opposition de phase fournis par le premier diviseur. Par rapport au premier des quatre signaux fournis par le diviseur maître-esclave, les autres signaux sont donc déphasés de 90°, 180° et 270°. Le bloc sélecteur comprend deux amplificateurs différentiels pour amplifier et sélectionner les quatre signaux déphasés, et des moyens de sélection pour fournir un des quatre signaux sélectionné en sortie.

Le bloc sélecteur est commandé par un bloc logique de commande en fonction du mode sélectionné. Dans un premier mode sélectionné, ledit circuit doit diviser la fréquence des signaux à haute fréquence par un facteur de division égal à 128. Dans ce cas, pour toutes les périodes de division, un seul des quatre signaux est sélectionné par le bloc sélecteur. Dans un second mode sélectionné, ledit circuit doit diviser la fréquence des signaux à haute fréquence par un facteur de division égal à 129. Pour obtenir ce facteur, une commutation de phase entre deux des quatre signaux déphasés est réalisée dans le bloc sélecteur en fonction des signaux de commande produits par le bloc de commande. A chaque période de division, une commutation de phase entre un premier signal fourni par le deuxième diviseur et un second signal en retard de phase de 90° par rapport au premier signal est donc réalisé. A cet effet, le bloc de commande est cadencé par le signal de sortie du dernier diviseur par deux pour fournir ainsi des signaux de commande au bloc sélecteur de phase pour la commutation de phase à chaque période de division.

Pour modifier l'état du bloc de commande en fonction d'un mode sélectionné, une porte logique du type NAND reçoit d'une part le signal de mode et le signal de sortie du dernier diviseur par deux. Lorsque le signal de mode vaut 0, la variation du signal de sortie sur le bloc de commande n'a aucun effet. Par contre lorsque le signal de mode vaut 1, le signal de sortie est inversé par la porte NAND afin de cadencer le bloc de commande et permettre au bloc sélecteur d'opérer la commutation de phase des signaux. Il est à noter que la partie de commande du bloc sélecteur n'est plus entièrement du type synchrone.

Un inconvénient majeur de la solution décrite dans l'article de Mrs Craninckx et Steyaert est qu'il peut apparaître des chutes de potentiel sur le signal de sortie du bloc sélecteur lors d'une commutation de phase dans le second mode sélectionné. Ces chutes de potentiel sont dues au passage du premier signal au second signal, qui est en retard de phase de 90° du premier signal, dans le bloc sélecteur. Dans ce cas, le facteur de division peut ne plus être égal à 129, mais être bien inférieur à 128 dû à une impulsion supplémentaire sur le signal de sortie du bloc sélecteur. Pour éviter ce problème, il est nécessaire que la fréquence des signaux à haute fréquence fournis à l'entrée dudit circuit soit élevée, car la partie logique pour la fourniture des signaux de commande ne réagit pas assez rapidement. Par contre si la fréquence desdits signaux à haute fréquence n'est pas suffisamment élevée, des chutes de potentiel apparaissent sur le signal de sortie lors de la commutation de phase.

Pour pallier à ce problème, il est nécessaire de ralentir dans une certaine mesure le début et/ou la pente de la transition des signaux de commande fournis par le bloc de commande. L'ajustement du début et/ou de la pente de transition des signaux de commande peut être difficile à réaliser pour tenir compte de la fréquence à diviser des signaux à haute fréquence reçus.

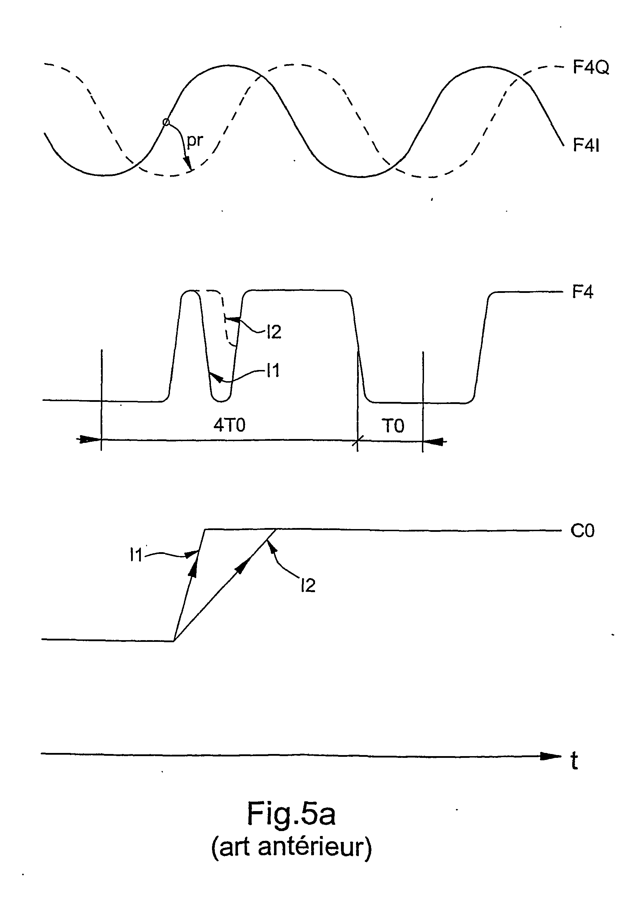

Comme on peut le remarquer sur la figure 5a, si le signal de commande C0 des moyens de sélection a une pente de transition 11 relativement raide, une chute de potentiel importante apparaît sur le signal de sortie F4. Par contre, si la pente de transition 12 est douce, la chute de potentiel sur le signal de sortie F4 n'a pratiquement plus d'influence sur le facteur de division. Toutefois, on comprend bien que ledit circuit, proposé dans l'article Mrs Jan Craninckx et Michiel S. J. Steyaert, n'est normalement pas en mesure de diviser des signaux dont la fréquence est relativement basse. Lesdits signaux à haute fréquence doivent avoir une fréquence supérieure à une fréquence minimale déterminée. De plus, le problème de chutes de potentiel est dépendant également de la tension d'alimentation du circuit compteur diviseur double mode. De ce fait, le circuit ne peut fonctionner qu'entre des tensions minimale et maximale déterminées.

L'invention a donc pour but principal de pallier les inconvénients de l'art antérieur en fournissant un circuit compteur diviseur double mode à haute vitesse ayant des moyens pour éviter, notamment, des chutes de potentiel intempestives lors d'une commutation de phase.

A cet effet, l'invention a pour objet un circuit compteur diviseur double mode du type cité ci-devant, dans lequel, dans un des deux modes sélectionné, le bloc de commande est agencé pour fournir des signaux de commande au bloc sélecteur pour qu'il opère une commutation de phase à chaque période de division entre deux signaux déphasés sélectionnés par chaque branche, qui sont de forme sensiblement sinusoïdale, le second signal déphasé étant en avance de phase de 90° du premier signal déphasé.

Un avantage du circuit compteur diviseur double mode, selon l'invention, est qu'il est indépendant de la fréquence des signaux à haute fréquence fournis à l'entrée du circuit. Grâce à une commutation de phase entre un premier signal et un second signal en avance de phase de 90° du premier signal, aucune chute de potentiel ne survient sur le signal de sortie du bloc sélecteur. De ce fait, il n'est pas nécessaire de devoir ralentir le début et/ou la pente de la transition des signaux de commande.

Le circuit compteur diviseur double mode à haute vitesse de la présente invention peut fonctionner d'une tension d'alimentation minimale déterminée à toute tension supérieure. La tension d'alimentation n'a plus d'influence sur la commutation de phase des signaux déphasés.

Un autre avantage du circuit compteur diviseur double mode, selon l'invention, est que les deux facteurs de division peuvent être choisis très proches l'un de l'autre. Cela permet ainsi d'ajuster finement la fréquence des signaux à haute fréquence dans la boucle à blocage de phase du synthétiseur de fréquence. Dans un premier mode sélectionné, la fréquence des signaux à haute fréquence peut être divisée par un premier facteur égal par exemple à 64. Dans un second mode sélectionné, la fréquence des signaux à haute fréquence peut être divisée par un second facteur égal par exemple à 63,5.

Un autre avantage du circuit compteur diviseur double mode, selon l'invention, est que le bloc de commande est cadencé de manière synchrone par un signal d'horloge correspondant au signal de sortie du dernier diviseur par deux de la chaîne de diviseurs. Ce signal d'horloge n'est donc jamais interrompu pour cadencer les opérations dans le bloc de commande. Par ailleurs, les signaux de commande produits par ledit bloc de commande sont exempts de toutes perturbations et/ou de tout retard.

De préférence, le bloc sélecteur de phase comprend une première branche de sélection recevant deux des quatre signaux déphasés, une seconde branche de sélection recevant deux autres signaux déphasés, et un élément de sélection relié à chaque branche. Chaque branche comprend un amplificateur différentiel commandé par un signal de commande pour la sélection d'un des deux signaux déphasés. Il est à noter que chaque signal de commande des amplificateurs est stabilisé avant chaque changement de signaux à sélectionner par l'élément de sélection du bloc sélecteur.

Il est à noter que l'emploi de diviseurs par deux, notamment du type asynchrone, dans la chaîne de diviseurs facilite la réalisation dudit circuit compteur diviseur double mode à haute vitesse.

Les buts, avantages et caractéristiques du circuit compteur diviseur double mode apparaîtront mieux dans la description suivante de formes d'exécution illustrées par les dessins sur lesquels :
La figure 1 déjà citée représente un synthétiseur de fréquence conventionnel avec un circuit compteur diviseur double mode,
la figure 2 représente schématiquement les différents éléments qui composent le circuit compteur diviseur double mode selon l'invention,
la figure 3 représente une forme d'exécution du bloc de commande qui est constitué de plusieurs bascules et de portes logiques pour le circuit compteur diviseur double mode selon l'invention,
la figure 4 représente des graphiques de la commutation de phase entre des signaux déphasés dans le bloc sélecteur en fonction de la transition des signaux de commande, ainsi que le signal de sortie du bloc sélecteur résultant de la commutation de phase des signaux déphasés,
la figure 5a déjà citée représente des graphiques de la commutation de phase entre un premier signal et un second signal en retard de phase de 90° du premier signal, ainsi que le signal de sortie du bloc sélecteur résultant de la commutation de phase des signaux déphasés selon l'art antérieur, et
la figure 5b représente des graphiques de la commutation de phase entre un premier signal et un second signal en avance de phase de 90° du premier signal, ainsi que le signal de sortie du bloc sélecteur résultant de la commutation de phase des signaux déphasés selon l'invention.

Dans la description suivante, il est à noter que tous le composants du circuit compteur diviseur double mode, qui sont bien connus d'un homme du métier dans ce domaine technique, ne seront pas expliqués en détail.

Comme décrit ci-devant en référence à la figure 1, le circuit compteur diviseur double mode est utilisé dans une boucle d'asservissement d'un synthétiseur de fréquence. Ce synthétiseur peut servir par exemple dans des dispositifs émetteurs et/ou récepteurs de signaux radiofréquences équipant des dispositifs portables de petite taille pour des communications sans fils à courte distance. La fréquence des signaux radiofréquences pour des communications courte distance est proche de 0,5 GHz, par exemple de 434 MHz. En général, ce synthétiseur sert à fournir des signaux à haute fréquence pour des opérations de démodulation des signaux radiofréquences. Le synthétiseur peut être prévu pour équiper par exemple une montre-bracelet qui comprend une batterie ou un accumulateur de petite taille. Le circuit compteur diviseur double mode doit être en mesure, notamment, de consommer peu de courant dans les périodes de fonctionnement du synthétiseur.

Le circuit compteur diviseur double mode, objet de l'invention, se base en partie sur le circuit présenté dans l'article rédigé par Mrs Jan Craninckx et Michiel S. J. Steyaert, publié dans le journal IEEE des circuits intégrés, volume 31 du 7 juillet 1996. Ainsi, le lecteur peut se reporter audit article pour plus de détails de conception de certains éléments équivalents du circuit compteur diviseur double mode, objet de l'invention.

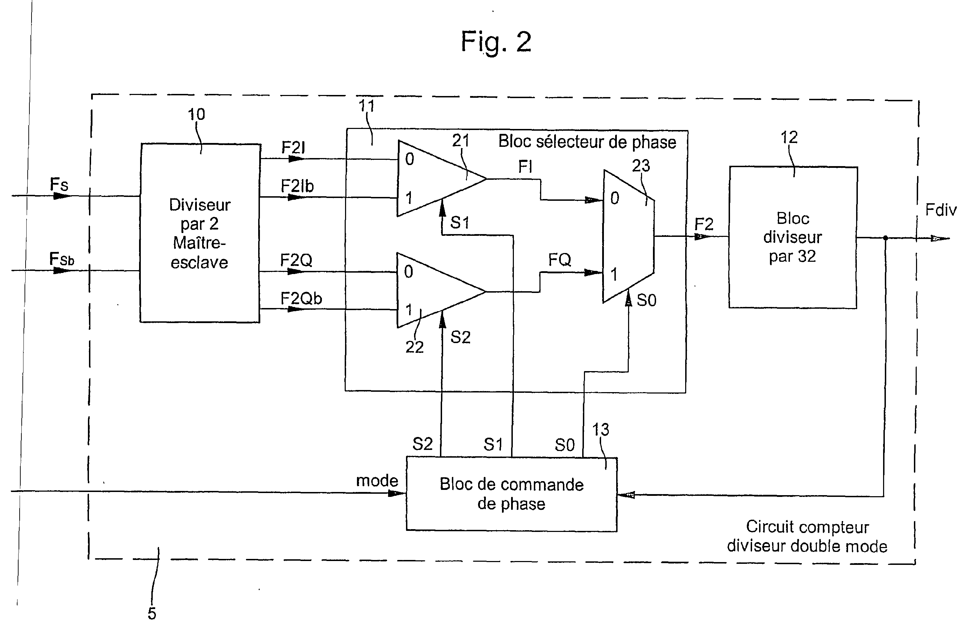

Les différents éléments du circuit compteur diviseur double mode 5 sont présentés à la figure 2. Le circuit est destiné à opérer une division par un premier facteur N dans un premier mode sélectionné et par un second facteur N-M dans un second mode sélectionné. De préférence, le facteur N est égal à 64, qui est une puissance de 2, alors que le facteur N-M est égal à 63,5. Bien entendu, d'autres valeurs de facteurs de division peuvent être choisis. Si le bloc sélecteur est par exemple intercalé entre les deuxième et troisième diviseurs par deux, les facteurs de division seront 64 ou 63.

Le circuit compteur diviseur double mode 5 comprend une chaîne de diviseurs par deux asynchrones 10, 12, un bloc sélecteur de phase 11 intercalé entre deux diviseurs par deux, et un bloc de commande de phase 13 relié au bloc sélecteur pour lui fournir des signaux de commande S0, S1 et S2 dépendant du mode sélectionné. Le bloc sélecteur de phase 11 est intercalé entre un premier diviseur du type maître-esclave 10 et le premier diviseur par deux du bloc diviseur 12.

Le diviseur maître-esclave fournit, au bloc sélecteur de phase 11, quatre signaux déphasés de 90° l'un par rapport à l'autre F2l, F2lb, F2Q et F2Qb en fonction de deux signaux à haute fréquence en opposition de phase Fs et Fsb. Les deux signaux à haute fréquence sont fournis par l'oscillateur différentiel commandé en tension (VCO) du synthétiseur. Il est à noter que le premier diviseur maître-esclave est le seul élément qui fonctionne à la plus haute fréquence.

La fréquence du signal de sortie F2 provenant du bloc sélecteur de phase 11 est divisée dans un bloc diviseur par trente-deux 12. Ce bloc diviseur par trente-deux n'est autre que cinq diviseurs par deux connectés en série du type asynchrone. Le signal de sortie Fdiv de ce bloc diviseur par trente-deux va servir de signal d'horloge pour le bloc de commande de phase 13 afin de cadencer les opérations traitées par ce bloc de commande. Le signal de sortie Fdiv est également un signal à fréquence divisée nécessaire pour la comparaison dans le détecteur de phase et de fréquence du synthétiseur de fréquence.

Le bloc sélecteur de phase 11 est composé de deux branches de sélection qui sont amplificatrices. Ces branches amplificatrices comprennent chacune un amplificateur différentiel 21 et 22. Chaque amplificateur 21 ou 22 reçoit deux des quatre signaux déphasés provenant du premier diviseur maître-esclave 10. Comme les signaux de ce diviseur ont une amplitude relativement faible, il est nécessaire d'amplifier lesdits signaux à l'aide de ces amplificateurs des deux branches.

L'amplificateur 21 reçoit par exemple les signaux en phase positif et négatif F21 et F21b, c'est-à-dire deux premiers signaux en opposition de phase, alors que l'amplificateur 22 reçoit les signaux en quadrature positif et négatif F2Q et F2Qb, c'est-à-dire deux seconds signaux en opposition de phase. Une sélection d'un des deux signaux dans chaque branche est réalisée à l'aide de signaux de commande S1, S2. Un signal de commande S1 permet de sélectionner soit le signal F21, soit le signal F21b. Lorsque le signal de commande S1 vaut 0, le signal F2I est amplifié et sélectionné par l'amplificateur 21, alors que lorsque le signal de commande S1 vaut 1, le signal opposé F21b est amplifié et sélectionné par l'amplificateur 21. De même, un signal de commande S2 permet de sélectionner soit le signal F2Q, soit le signal F2Qb. Lorsque le signal de commande S2 vaut 0, le signal F2Q est amplifié et sélectionné par l'amplificateur 22, alors que lorsque le signal de commande S2 vaut 1, le signal opposé F2Qb est amplifié et sélectionné par l'amplificateur 22. On comprend bien que le choix des signaux déphasés pour chaque amplificateur peut être changé, mais pour la présente invention il s'avère qu'il est préférable de choisir les signaux décrits ci-dessus pour chaque amplificateur.

Les amplificateurs 21, 22 sont alimentés par exemple chacun par une source de courant non représentée dont la valeur du courant doit être suffisamment importante pour garantir un fonctionnement rapide du circuit compteur diviseur double mode. Toutefois, lesdits amplificateurs peuvent aussi être alimentés par une source de tension.

Le bloc sélecteur de phase 11 comprend encore un élément de sélection 23 d'un des signaux déphasés à fournir en sortie dudit bloc. L'élément de sélection peut être par exemple un multiplexeur. Cet élément de sélection reçoit les signaux Fl et FQ de chaque branche, ainsi qu'un signal de commande S0. Ce signal S0 permet, à l'élément de sélection 23, de sélectionner l'un ou l'autre des signaux Fl et FQ à fournir en sortie. Lorsque le signal S0 vaut 0, le signal Fl est sélectionné, alors que lorsque le signal S0 vaut 1, le signal FQ est sélectionné.

Dans un premier mode sélectionné, aucune commutation de phase n'est opérée dans le bloc sélecteur de phase 11. Ainsi, le bloc sélecteur ne sélectionne qu'un des quatre signaux déphasés pour fournir un signal de sortie F2 à la même fréquence que le signal déphasé sélectionné. Le même signal déphasé constitue le signal de sortie F2 du bloc sélecteur à chaque période de division. Cette période de division est définie par rapport à la fréquence du signal à fréquence divisée Fdiv en sortie du circuit compteur diviseur 5. Dans ce premier mode, les signaux de commande S0, S1 et S2 fournis par le bloc de commande 13 ne varient donc pas au cours du temps.

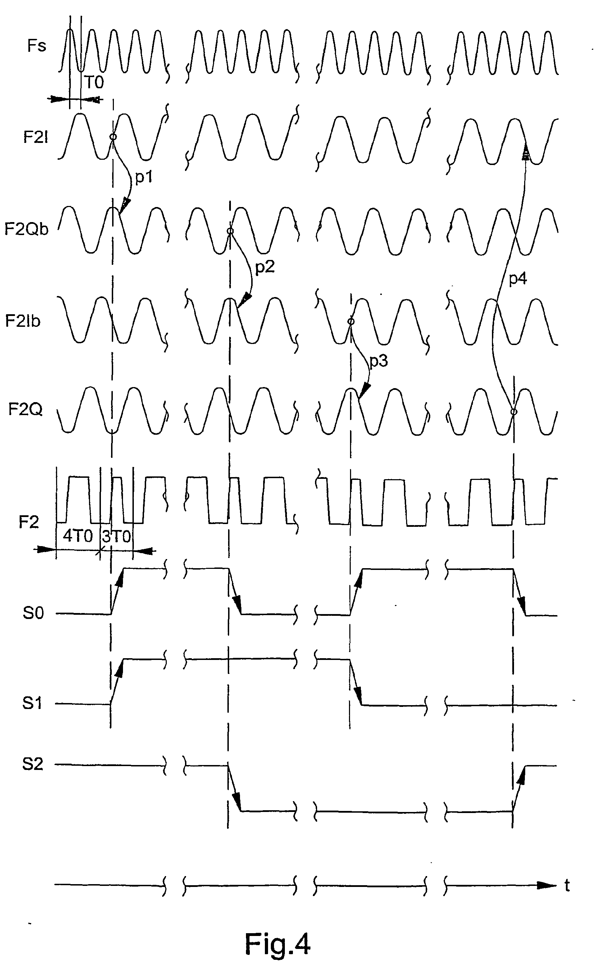

Dans un second mode sélectionné, une commutation de phase est opérée dans le bloc sélecteur à la fin de chaque période de division. La commutation de phase dans le bloc sélecteur correspond à une transition entre un premier signal reçu à l'entrée du bloc sélecteur et un second signal en avance de phase de 90°. Ainsi, le bloc sélecteur 11 reçoit des signaux de commande S0, S1 et S2 dont certains changent d'état à chaque période de division 1/Fdiv pour la commutation de phase. Comme l'écart de phase entre chaque signal déphasé est de 90° et qu'un seul diviseur par deux précède le bloc sélecteur, le second facteur de division peut ainsi être égal à 63,5. Six diviseurs par deux, associés au bloc sélecteur de phase, sont employés pour obtenir un tel facteur dans la présente invention. La commutation de phase, c'est-à-dire la transition entre deux des quatre signaux déphasés à chaque période de division, sera expliquée notamment en référence à la figure 4.

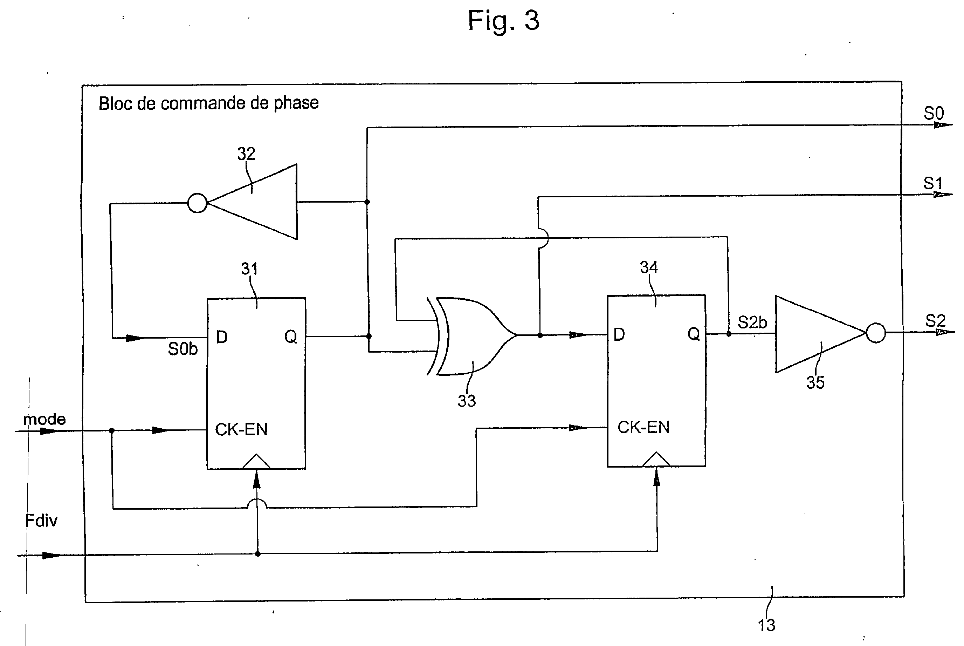

Le bloc de commande de phase 13, représenté à la figure 3, peut être configuré pour fournir des signaux de commande S0, S1 et S2 au bloc sélecteur dépendant de l'état d'un signal de mode. Dans cette forme d'exécution, le bloc de commande 13 comprend une partie à logique séquentielle et une partie à logique combinatoire. La partie à logique séquentielle comprend deux bascules 31 et 34, et la partie à logique combinatoire comprend un agencement de portes logiques 32, 33 et 35. Il est à noter que la partie à logique séquentielle est cadencée de manière synchrone par un unique signal d'horloge Fdiv. Ce signal d'horloge est le signal de sortie du diviseur par deux de la chaîne de diviseurs.

Lorsque le signal de mode est à l'état 1, toutes les bascules de type D transmettent l'état du signal d'entrée à leur sortie Q à chaque coup d'horloge produit par le signal Fdiv. Par contre, lorsque le signal de mode est à l'état 0, l'état des sorties de chaque bascule ne fluctue pas à chaque coup d'horloge produit par le signal Fdiv.

Un inverseur 32 est connecté entre la sortie Q de la première bascule 31 et l'entrée D afin que le signal de sortie S0 soit inversé par ledit inverseur pour donner le signal S0b. De ce fait, à chaque coup d'horloge, le signal S0 change d'état. Il passe de l'état bas à l'état haut quand le signal S0b est à l'état haut, et il passe de l'état haut à l'état bas quand le signal S0b est à l'état bas.

Une porte logique XOR 33 reçoit à l'entrée le signal S0 et le signal de sortie Q de la deuxième bascule 34, qui correspond au signal S2b, et fournit un signal S1 à l'entrée de la deuxième bascule. Finalement, le signal de commande S2 est obtenu par le signal S2b inversé par l'inverseur 35.

Il est à noter que le bloc de commande 13 fonctionne avec des signaux dont la fréquence est près de 32 fois inférieure aux signaux déphasés placés à l'entrée des amplificateurs de chaque branche. La faible consommation en courant des bascules et des portes logiques de ce bloc 13 n'affecte que dans une moindre mesure la consommation du circuit compteur diviseur double mode comparativement au bloc sélecteur de phase 11.

Dans une autre forme d'exécution non représentée sur une figure, le bloc de commande peut comprendre un compteur et une mémoire non volatile du type ROM.

La mémoire ROM comprend un certain nombre de positions mémoire dans lesquelles sont enregistrés des mots binaires de 3 bits représentant l'état de chaque signal de commande à un instant donné. Dans le second mode sélectionné, toutes les positions mémoire sont adressables successivement de manière cyclique par le compteur. Le compteur passe donc d'une adresse précédente d'une position mémoire à une adresse successive à chaque coup d'horloge. Ce signal d'horloge est produit par le signal de sortie Fdiv du dernier diviseur par deux de la chaîne de diviseurs. De ce fait, certains signaux de commande changent d'état à chaque coup d'horloge en passant d'une position mémoire précédente à une position mémoire suivante. Dans le premier mode sélectionné, uniquement une position mémoire est sélectionnée à chaque coup d'horloge.

Ce bloc de commande avec la mémoire ROM ne sera pas décrit de manière détaillée, car il fait partie des connaissances générales d'un homme du métier dans ce domaine technique.

La commutation des signaux déphasés dans le bloc sélecteur de phase en fonction des signaux de commande est expliquée maintenant en référence à la figure 4. Cette figure présente plusieurs graphiques des signaux notamment au niveau du bloc sélecteur. Les quatre commutations en avance de phase p1 à p4 dans le bloc sélecteur intervenant à chaque période de division sont montrées.

Sur les graphiques, les signaux Fs, F2l, F2lb, F2Q et F2Qb sont représentés de forme approximativement sinusoïdale. Il faut savoir que le premier diviseur maître-esclave fonctionne à haute fréquence, c'est pourquoi il est plus avantageux d'avoir des signaux de forme sinusoïdale plutôt que des signaux à impulsions sensiblement rectangulaires. Cela permet d'éviter d'avoir un spectre de fréquence trop étendu dans le cas où les signaux sont à impulsions rectangulaires, et de réduire la consommation de ce premier diviseur.

Le signal à haute fréquence Fs a une fréquence qui peut être de l'ordre de 434 MHz. Après le premier diviseur par deux, les signaux déphasés F21, F2Q, F21b et F2Qb ont tous une fréquence divisée par deux de la fréquence du signal Fs. Par rapport au signal F21, le signal F2Qb a une avance de phase de 90°, le signal F21b a une avance de phase de 180° et le signal F2Q a une avance de phase de 270°. Chaque signal F21, F2Q, F21b et F2Qb est donc déphasé l'un par rapport à l'autre d'une demi période T0 du signal Fs.

Lorsque le signal S2 est à l'état 1 et que les signaux S0 et S1 passent de l'état 0 à l'état 1, une première commutation de phase p1 entre le signal F21 et F2Qb est opérée dans le bloc sélecteur. Ainsi le signal de sortie F2, devant représenter un des signaux déphasés sélectionné, a une impulsion plus courte d'une demi période T0 à la fin de chaque période de division due à la commutation de phase. Ainsi, la période du signal F2 avec cette courte impulsion est de 3T0 alors qu'avant commutation elle valait 4T0.

Lorsque le signal S1 est à l'état 1 et que les signaux S0 et S2 passent de l'état 1 à l'état 0, une seconde commutation de phase p2 entre le signal F2Qb et F2lb est opérée dans le bloc sélecteur. De nouveau, le signal de sortie F2 a une impulsion plus courte d'une demi période du signal Fs à la fin de la période de division due à la commutation de phase.

Lorsque le signal S2 est à l'état 0 et que le signal S0 passe de l'état 0 à l'état 1 et que le signal S1 passe de l'état 1 à l'état 0, une troisième commutation de phase p3 entre le signal F2lb et F2Q est opérée dans le bloc sélecteur. De nouveau, le signal de sortie F2 a une impulsion plus courte d'une demi période du signal Fs à la fin de la période de division due à la commutation de phase.

Finalement, lorsque le signal S1 est à l'état 0 et que le signal S0 passe de l'état 1 à l'état 0 et que le signal S2 passe de l'état 0 à l'état 1, une quatrième commutation de phase p4 entre le signal F2Q et F2l est opérée dans le bloc sélecteur. De nouveau, le signal de sortie F2 a une impulsion plus courte d'une demi période du signal Fs à la fin de la période de division due à la commutation de phase.

On comprend donc bien qu'en diminuant d'une demi période T0 du signal Fs l'impulsion du signal F2 à chaque période de division, le circuit compteur diviseur divise la fréquence du signal Fs par 63,5. Comme l'impulsion de tension est relativement courte lors d'une commutation en avance de phase, il s'ensuit inévitablement une légère augmentation du courant par rapport à une commutation en retard de phase traditionnelle.

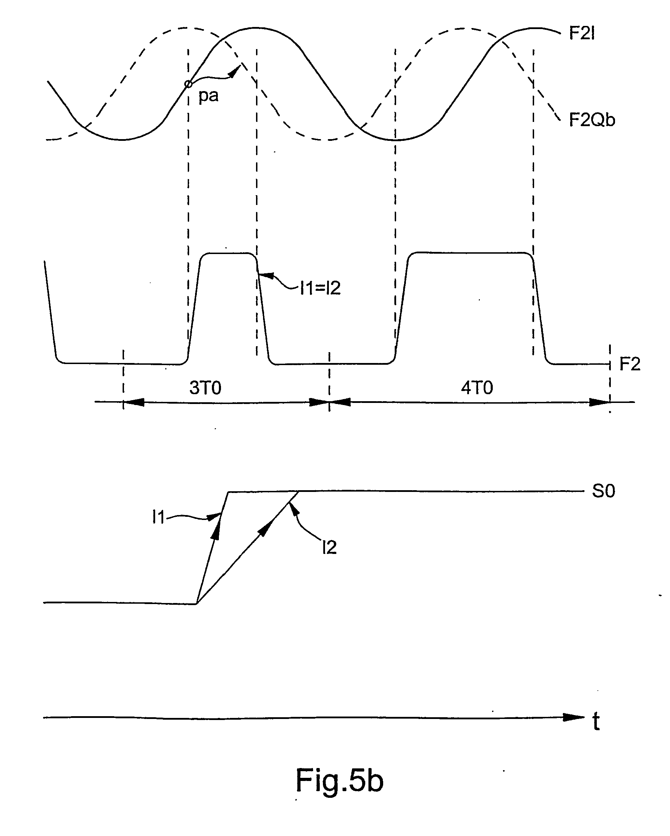

On va se référer maintenant aux figures 5a et 5b qui représentent des graphiques montrant l'avantage d'une commutation en avance de phase par rapport à une commutation en retard de phase dans le bloc sélecteur.

La figure 5a, qui a déjà été décrite ci-dessus, montre la forme du signal de sortie F4 du bloc sélecteur de phase lors de la commutation entre un premier signal F41 et un second signal F4Q en retard de phase de 90° du premier signal. Le circuit compteur diviseur double mode, qui fournit ce signal de sortie F4, est celui décrit dans l'article de Mrs Jan Craninckx et Michiel S. J. Steyaert (art antérieur).

Lorsque la fréquence des signaux à haute fréquence n'est pas suffisamment élevée, la pente de la transition du signal de commande C0 de l'état 0 à l'état 1 pour la commutation de phase a une grande, importance. Si la pente l1 de la transition du signal C0 est assez raide, une chute de potentiel importante apparaît sur le signal de sortie F4 lors de la commutation de phase pr entre le signal F4l et F4Q. Afin de minimiser la chute de potentiel, il est donc nécessaire d'adapter le circuit pour que la pente de transition du signal de commande C0 soit moins raide. Ainsi, lorsque le signal de commande C0 a une pente l2 de transition de l'état 0 à l'état 1, la chute de potentiel est suffisamment réduite pour ne pas avoir d'influence sur le facteur de division sélectionné.

On se rend bien compte qu'il est difficile d'adapter le circuit compteur diviseur en fonction de la fréquence du signal à haute fréquence pour éviter des chutes de potentiel sur le signal de sortie F4 lors d'une commutation en retard de phase. Ainsi, la fréquence du signal à haute fréquence ne peut pas être inférieure à une valeur seuil déterminée.

La figure 5b montre la forme du signal de sortie F2 du bloc sélecteur de phase lors de la commutation entre un premier signal F2l et un second signal F2Qb en avance de phase de 90° du premier signal selon l'invention. Comparativement à la figure 5a, aucune chute de potentiel n'apparaît lors de la commutation de phase pa entre un premier signal F2l et un second signal F2Qb en avance de phase de 90° du premier signal. Que la pente de la transition du signal de commande S0 soit raide l1 ou moins raide 12, cela n'a aucune influence sur le signal de sortie F2 du bloc sélecteur de phase. Ainsi, en faisant une commutation en avance de phase selon l'invention, on évite ces chutes de potentiel intempestives sur le signal de sortie F2. Le circuit compteur diviseur, objet de l'invention, est donc en mesure de diviser des signaux d'une fréquence proche de 0 à une valeur maximale dépendant par exemple du procédé de fabrication du circuit. La limite maximale de la fréquence des signaux à haute fréquence peut être supérieure à 2 GHz.

A partir de la description qui vient d'être faite de multiples variantes de réalisation du circuit compteur diviseur, peuvent être conçues par l'homme du métier sans sortir du cadre de l'invention définie par les revendications. Par exemple, le bloc sélecteur de phase peut comprendre un multiplexeur à quatre entrées pour recevoir les quatre signaux déphasés au lieu des deux amplificateurs des deux branches et de l'élément de sélection. Le multiplexeur doit être en mesure de sélectionner un des quatre signaux à fournir en sortie dudit bloc. Dans ce cas, uniquement deux signaux de commande provenant du bloc de commande suffisent pour ledit multiplexeur afin d'opérer la sélection d'un des quatre signaux déphasés.

## Revendications

1. Circuit compteur diviseur double mode pour un synthétiseur de fréquence (1), ledit circuit comprenant :
- plusieurs diviseurs par deux (10, 12) connectés en série du type asynchrone, un des diviseurs étant du type maître-esclave (10) pour recevoir deux signaux d'entrée (Fs, Fsb) en opposition de phase et fournir quatre signaux déphasés de 90° (F21, F21b, F2Q, F2Qb) l'un par rapport à l'autre,
- un bloc sélecteur de phase (11) intercalé entre deux des diviseurs (10, 12) par deux pour recevoir les quatre signaux déphasés du premier diviseur maître-esclave et fournir un des quatre signaux déphasés sélectionné au second diviseur, des signaux de commande (S0, S1, S2) étant fournis audit bloc sélecteur afin qu'il fournisse en sortie un des quatre signaux déphasés sélectionné (F2) dans une période de division déterminée en fonction d'un mode de division sélectionné,
- un bloc de commande (13) pour fournir les signaux de commande au bloc sélecteur, ledit bloc de commande recevant un signal de sortie (Fdiv) d'un des diviseurs par deux pour cadencer des opérations dans le bloc de commande, et un signal pour la sélection du mode, dans un des deux modes sélectionné, le bloc de commande (13) étant agencé pour fournir des signaux de commande (S0, S1, S2) au bloc sélecteur pour qu'il opère une commutation de phase à chaque période de division entre deux signaux déphasés sélectionnés, qui sont de forme sensiblement sinusoïdale, le second signal déphasé étant en avance de phase de 90° du premier signal déphasé,
le circuit compteur diviseur double mode étant **caractérisé en ce que** ledit bloc sélecteur (11) comprend une première branche de sélection, qui est constituée d'un premier amplificateur différentiel (21) recevant deux premiers signaux déphasés (F21, F21b), une seconde branche de sélection, qui est constituée d'un second amplificateur différentiel (22) recevant deux seconds signaux déphasés (F2Q, F2Qb), et un élément de sélection (23) relié à chaque amplificateur, les signaux de commande (S0, S1, S2) étant fournis aux premier et second amplificateurs afin de fournir à leur sortie un des deux signaux déphasés, ainsi qu'à l'élément de sélection.

2. Circuit compteur diviseur selon la revendication 1, **caractérisé en ce que** le bloc de sélection de phase est inséré entre le premier et le deuxième diviseurs par deux pour recevoir les quatre signaux du premier diviseur par deux (10) qui est du type maître/esclave.

3. Circuit compteur diviseur selon l'une des revendications précédentes, **caractérisé en ce qu'**il comprend six diviseurs par deux (10, 12) du type asynchrone pour obtenir une division de fréquence par un facteur égal à 64 dans un premier mode, dans lequel les signaux de commande (S0, S1, S2) ne changent pas d'état à chaque période de division déterminée pour qu'un seul des quatre signaux déphasés soit sélectionné dans le bloc sélecteur, et pour obtenir une division de fréquence par un facteur égal à 63,5 dans un second mode, dans lequel, pour chaque période de division déterminée, certains signaux de commande changent d'état pour opérer une commutation de phase entre un premier signal déphasé et un second signal déphasé en avance de phase de 90° du premier signal déphasé afin que le bloc sélecteur fournisse en sortie un des quatre signaux déphasés différent à la fin de chaque période de division.

4. Circuit compteur diviseur selon la revendication 1, **caractérisé en ce que** le bloc de commande comprend deux bascules (31, 34) du type D cadencées de façon synchrone par le signal de sortie (Fdiv) du dernier diviseur par deux, et un agencement de portes logiques (32, 33, 35) pour la fourniture des signaux de commande au bloc sélecteur.

5. Circuit compteur diviseur selon la revendication 4, **caractérisé en ce qu'**un premier inverseur (32) est placé entre une sortie non inverseuse et une entrée de la première bascule (31), le signal de sortie de la première bascule foumissant le signal de commande (S0) de l'élément de sélection (23), **en ce qu'**une porte logique du type XOR (33) reçoit en entrée le signal de sortie de la première bascule et un signal de sortie non inverseuse de la deuxième bascule (34) pour fournir un signal d'entrée de la deuxième bascule qui correspond au signal de commande (S1 ) de la première branche (21), et **en ce qu'**un second inverseur (35) est branché à la sortie non inverseuse de la deuxième bascule pour fournir le signal de commande (S2) de la deuxième branche (22).

6. Circuit compteur diviseur selon la revendication 1, **caractérisé en ce que** le bloc de commande comprend une mémoire non volatile, par exemple une mémoire du type ROM, dans laquelle plusieurs mots binaires sont enregistrés dans des positions déterminées, chaque mot binaire représentant l'état des signaux de commande pour chaque période de division déterminée, et un compteur cadencé par le signal de sortie du dernier diviseur par deux de manière à adresser à chaque transition du compteur une position mémoire successive dans un second mode sélectionné ou à maintenir une position mémoire déterminée dans un premier mode sélectionné.

7. Circuit compteur diviseur selon l'une des revendications 1 et 3, **caractérisé en ce que** la première branche reçoit deux signaux déphasés en opposition de phase (F2l, F2lb), **en ce que** la seconde branche reçoit deux autres signaux déphasés en opposition de phase (F2Q, F2Qb), et **en ce que** les signaux de commande sont agencés de telle manière que, lors d'une commutation de phase entre des premier et second signaux déphasés sélectionnés dans l'élément de sélection du bloc sélecteur, la sélection du second signal déphasé dans une des branches respectives est réalisée dans une période précédent la commutation de phase dans l'élément de sélection.

## Claims

1. Dual-modulus prescaler circuit, in particular for a frequency synthesizer (1), said circuit comprising:
- a plurality of asynchronous dividers-by-two (10, 12) connected in series, one of the dividers (10) being of the master-slave type, for receiving two input signals (Fs, Fsb) of phase opposition, and supplying four signals phase shifted by 90° (F21, F21b, F2Q, F2Qb) in relation to each other,
- a phase selector unit (11) inserted between two of the dividers-by-two (10, 12) for receiving the four phase shifted signals from the master-slave first divider and supplying a selected one of the four phase shifted signals to the second divider, control signals (S0, S1, S2) being supplied to said selector unit so that it supplies at its output a selected one of the four phase shifted signals (F2) in a division period determined as a function of a selected division mode,
- a control unit (13) for supplying the control signals to the selector unit, said control unit receiving an output signal (Fdiv) of one of the dividers-by-two for clocking operations in the control unit, and a signal for selecting the mode, in one selected of the two modes, the control unit (13) being adapted to supply control signals (S0, S1, S2) to the selector unit so that it effects phase switching in each division period between two selected phase shifted signals, which are of a substantially sinusoidal shape, the second phase shifted signal being in phase lead of 90° in relation to the first phase shifted signal,
the dual-modulus prescaler circuit being **characterized in that** said selector unit (11) comprises a first selector branch, which is constituted by a first differential amplifier (21) receiving two first phase shifted signals (F21, F21b), a second selector branch, which is constituted by a second differential amplifier (22) receiving two second phase shifted signals (F2Q, F2Qb), and a selection element (23) connected to each amplifier, the control signals (S0, S1, S2) being supplied to the first and second amplifiers in order to supply at their output one of the two phase shifted signals, and to the selection element.

2. Prescaler circuit according to claim 1, **characterized in that** the phase selector unit is between the first and second dividers-by-two and receives the four signals from the master-slave first divider-by-two (10).

3. Prescaler circuit according to any of the preceding claims, **characterized in that** it comprises six asynchronous dividers-by-two (10, 12) to obtain frequency division by a factor equal to 64 in a first mode wherein the control signals (S0, S1, S2) do not change state in each particular division period so only one of the four phase shifted signals is selected in the selector unit and to obtain frequency division by a factor equal to 63,5 in a second mode wherein, in each particular division period, certain control signals change state to effect phase switching between a first phase shifted signal and a second phase shifted signal in phase lead of 90° in relation to the first phase shifted signal so that the selector unit supplies at its output a different one of the four phase shifted signals at the end of each division period.

4. Prescaler circuit according to claim 1, **characterized in that** the control unit comprises two D-type flip-flops (31, 34) clocked synchronously by the output signal (Fdiv) of the last divider-by-two and an arrangement of logic gates (32, 33, 35) for supplying control signals to the selector unit.

5. Prescaler circuit according to claim 4, **characterized in that** a first inverter (32) is placed between a non-inverting output and an input of the first flip-flop (31), the output signal of the first flip-flop supplying the control signal (S0) of the selection element (23), **in that** an XOR logic gate (33) receives at its input the output signal of the first flip-flop and a non-inverting output signal of the second flip-flop (34), to supply an input signal of the second flip-flop that corresponds to the control signal (S1) of the first branch (21), and **in that** a second inverter (35) is connected to the non-inverting output of the second flip-flop, to supply the control signal (S2) of the second branch (22).

6. Prescaler circuit according to claim 1, **characterized in that** the control unit includes a non-volatile memory, for example a read-only memory, for storing a plurality of binary words at particular locations, each binary word representing the state of the control signals for each particular division period, and a counter clocked by the output signal of the last divider-by-two, to send a successive memory location on each counter transition in a second selected mode or to maintain a particular memory location in a first selected mode.

7. Prescaler circuit according to any of claims 1 and 3, **characterized in that** the first branch receives two phase shifted signals (F2l, F2lb) in phase opposition, **in that** the second branch receives two other phase shifted signals (F2Q, F2Qb) in phase opposition, and **in that** the control signals are such that, on phase switching between first and second selected phase shifted signals in the selection element of the selector unit, the selection of the second phase shifted signal in one of the respective branches is effected in a period preceding phase switching in the selection element.

## Patentansprüche

1. Doppelbetrieb-Zähler/Dividierer-Schaltung für einen Frequenzsynthetisierer (1), wobei die Schaltung umfasst:
- mehrere Dividierer durch zwei (10, 12), die in einer Reihe des asynchronen Typs verschaltet sind, wobei einer der Dividierer vom Master/Slave-Typ (10) ist, um zwei Eingangssignale (Fs, Fsb) mit entgegengesetzter Phase zu empfangen und um vier zueinander um 90° phasenverschobene Signale (F2l, F2lb, F2Q, F2Qb) zu liefern,
- einen Phasenauswahlblock (11), der zwischen zwei der Dividierer (10, 12) durch zwei eingefügt ist, um die vier phasenverschobenen Signale des ersten Master/Slave-Dividierers zu empfangen und um ein ausgewähltes der vier phasenverschobenen Signale an den zweiten Dividierer zu liefern, wobei an den Auswahlblock Steuersignale (S0, S1, S2) geliefert werden, damit er am Ausgang ein ausgewähltes (F2) der vier phasenverschobenen Signale in einer in Abhängigkeit von einer ausgewählten Divisionsbetriebsart bestimmten Divisionsperiode liefert,
- einen Steuerblock (13) zum Liefern der Steuersignale an den Auswahlblock, wobei der Steuerblock ein Ausgangssignal (Fdiv) von einem der Dividierer durch zwei empfängt, um Operationen in dem Steuerblock zu takten, und ein Betriebsartauswahlsignal in einer ausgewählten der zwei Betriebsarten empfängt, wobei der Steuerblock (13) so beschaffen ist, dass er die Steuersignale (S0, S1, S2) an den Auswahlblock liefert, damit er in jeder Divisionsperiode zwischen zwei ausgewählten phasenverschobenen Signalen, die im Wesentlichen sinusförmig sind, eine Phasenumschaltung bewerkstelligt, wobei das zweite phasenverschobene Signal in Bezug auf das erste phasenverschobene Signal eine Phasenvoreilung von 90° besitzt,
wobei die Doppelbetrieb-Zähler/Dividierer-Schaltung **dadurch gekennzeichnet ist, dass** der Auswahlblock (11) einen ersten Auswahlzweig, der aus einem ersten Differenzverstärker (21) gebildet ist, der zwei erste phasenverschobene Signale (F2l, F2lb) empfängt, einen zweiten Auswahlzweig, der aus einem zweiten Differenzverstärker (22) gebildet ist, der zwei zweite phasenverschobene Signale (F2Q, F2Qb) empfängt, und ein Auswahlelement (23), das mit jedem Verstärker verbunden ist, umfasst, wobei die Steuersignale (S0, S1, S2) an den ersten und an den zweiten Verstärker geliefert werden, damit sie an ihrem Ausgang eines der zwei phasenverschobenen Signale liefern, und an das Auswahlelement geliefert werden.

2. Zähler/Dividierer-Schaltung nach Anspruch 1, **dadurch gekennzeichnet, dass** der Phasenauswahlblock zwischen den ersten und den zweiten Dividierer durch zwei eingefügt ist, um die vier Signale des ersten Dividierers durch zwei (10), der vom Master/Slave-Typ ist, zu empfangen.

3. Zähler/Dividierer-Schaltung nach einem der vorhergehenden Ansprüche, **dadurch gekennzeichnet, dass** sie sechs Dividierer durch zwei (10, 12) des asynchronen Typs umfasst, um in einer ersten Betriebsart eine Frequenzdivision durch einen Faktor auszuführen, der gleich 64 ist, in der die Steuersignale (S0, S1, S2) ihren Zustand nicht für jede bestimmte Divisionsperiode ändern, damit nur eines der vier phasenverschobenen Signale in dem Auswahlblock ausgewählt wird, und um in einer zweiten Betriebsart eine Frequenzdivision durch einen Faktor auszuführen, der gleich 63,5 ist, in der bestimmte Steuersignale ihren Zustand für jede bestimmte Divisionsperiode ändern, um eine Phasenumschaltung zwischen einem ersten phasenverschobenen Signal und einem zweiten phasenverschobenen Signal, das in Bezug auf das erste phasenverschobene Signal eine Phasenvoreilung von 90° aufweist, zu erhalten, damit der Auswahlblock am Ende jeder Divisionsperiode am Auswahlblock jeweils ein anderes der vier phasenverschobenen Signale liefert.

4. Zähler/Dividierer-Schaltung nach Anspruch 1, **dadurch gekennzeichnet, dass** der Steuerblock zwei Kippschaltungen (31, 34) des Typs D umfasst, die synchron durch das Ausgangssignal (Fdiv) des ersten Dividierers durch zwei getaktet werden, und eine Logikgatter-Anordnung (32, 33, 35) umfasst, um die Steuersignale an den Auswahlblock zu liefern.

5. Zähler/Dividierer-Schaltung nach Anspruch 4, **dadurch gekennzeichnet, dass** zwischen einen nicht invertierenden Eingang und einen Eingang der ersten Kippschaltung (31) ein erster Inverter (37) geschaltet ist, wobei das Ausgangssignal der ersten Kippschaltung das Steuersignal (S0) des Auswahlelements (23) liefert, dass ein Logikgatter des Typs XOR (33) am Eingang das Ausgangssignal der ersten Kippschaltung und ein Signal des nicht invertierenden Ausgangs der zweiten Kippschaltung (34) empfängt, um ein Eingangssignal der zweiten Kippschaltung zu liefern, das dem Steuersignal (S1) des ersten Zweigs (21) entspricht, und dass ein zweiter Inverter (35) an den nicht invertierenden Ausgang der zweiten Kippschaltung angeschlossen ist, um das Steuersignal (S2) des zweiten Zweigs (22) zu liefern.

6. Zähler/Dividierer-Schaltung nach Anspruch 1, **dadurch gekennzeichnet, dass** der Steuerblock einen nichtflüchtigen Speicher, beispielsweise einen Speicher des Typs ROM, umfasst, in den an bestimmten Positionen mehrere binäre Wörter eingetragen sind, wobei jedes binäre Wort den Zustand der Steuersignale für jede bestimmte Divisionsperiode repräsentiert, und einen Zähler umfasst, der durch das Ausgangssignal des letzten Dividierers durch zwei in der Weise getaktet wird, dass bei jedem Übergang des Zählers eine aufeinander folgende Speicherposition in einer ausgewählten zweiten Betriebsart adressiert wird oder eine bestimmte Speicherposition in einer ausgewählten ersten Betriebsart beibehalten wird.

7. Zähler/Dividierer-Schaltung nach einem der Ansprüche 1 und 3, **dadurch gekennzeichnet, dass** der erste Zweig zwei phasenverschobene Signale (F2l, F2lb) mit entgegengesetzter Phase empfängt, dass der zweite Zweig zwei weitere phasenverschobene Signale (F2Q, F2Qb) mit entgegengesetzter Phase empfängt und dass die Steuersignale so beschaffen sind, dass bei einer Phasenumschaltung zwischen dem ersten und dem zweiten phasenverschobenen Signal, die in dem Auswahlelement des Auswahlblocks ausgewählt werden, die Auswahl des zweiten phasenverschobenen Signals in einem der jeweiligen Zweige in einer Periode erfolgt, die der Phasenumschaltung in dem Auswahlelement vorhergeht.
